# EUROPEAN PATENT APPLICATION

(11) **EP 2 368 662 A1**
(43) Date of publication of application: **28.09.2011**
(21) Application number: 09833503.7
(22) Date of filing: 18.12.2009
(51) Int. Cl.: B23K 26/36, B23K 26/00, B23K 26/03, H01L 21/027, H01L 31/04

(54) **FILM REMOVAL METHOD, PHOTOELECTRIC CONVERSION DEVICE MANUFACTURING METHOD, PHOTOELECTRIC CONVERSION DEVICE, AND FILM REMOVAL DEVICE**

(30) Priority: 19.12.2008 JP 2008324294
(71) Applicant: Sharp Kabushiki Kaisha, Osaka-shi, Osaka 545-8522 (JP)
(72) Inventor: TOYOKAWA, Masahiro, Osaka-shi Osaka 545-8522 (JP); TACHIBANA, Shinsuke, Osaka-shi Osaka 545-8522 (JP)
(74) Representative: Müller - Hoffmann & Partner
(86) International application number: PCT/JP2009/071162
(87) International publication number: WO 2010/071201

(57) **Abstract**

A film (3) formed on a substrate (2) is radiated with a first light beam to separate the film (3) into a plurality of regions. Repairing (RP1) is carried out by removing the film (3) at a removal deficient site (DP) where the film (3) remains between the plurality of regions. A film removal method allowing separation of a film (3) into a plurality of regions at high yield, a method for fabricating a photoelectric conversion device (1) using the film removal method, and a film removal device (60) can be provided.

## Description

### TECHNICAL FIELD

The present invention relates to a film removal method, a method for fabricating a photoelectric conversion device, a photoelectric conversion device, and a film removal device.

### BACKGROUND ART

The fabrication of a photoelectric conversion device and the like may include the step of separating a conductive film on a substrate into a plurality of regions by removing a portion of the conductive film. For example, according to Japanese Patent Laying-Open No. 2002-261308 (Patent Document 1), the method for fabricating a photoelectric conversion device includes the following steps.

First, a transparent front electrode layer is grown on a transparent substrate. The transparent front electrode layer is divided into a plurality of cells by having a first separation trench formed by laser scribing. On the transparent front electrode layer, a first thin film photoelectric conversion unit and an intermediate reflection layer are grown, followed by laser scribing. A second thin film photoelectric conversion unit is grown on the intermediate reflection layer. A connection trench is formed by laser scribing in the first and second thin film photoelectric conversion units and intermediate reflection layer. Then, a back electrode layer is formed on the second thin film photoelectric conversion unit. A second separation trench is formed by laser scribing in the first and second thin film photoelectric conversion units, intermediate reflection layer, and back electrode layer. A power generation region is determined by further laser scribing. A pair of electrode bus bars is provided at either end of the cell row.

Thus, a thin film photoelectric conversion device is obtained.

### PRIOR ART DOCUMENT

### PATENT DOCUMENT

Patent Document 1: Japanese Patent Laying-Open No. 2002-261308

### SUMMARY OF THE INVENTION

### PROBLEM TO BE SOLVED BY THE INVENTION

In the case where there is a scratch or defect at the transparent substrate, or on a film formed on the transparent substrate, there may be a deficiency of the film remaining at an area between regions that should be separated from each other in the film.
Similar deficiencies may occur due to other causes such as variation in the processing steps. As a result, there was a problem that the process yield is reduced.

In view of the foregoing, an object of the present invention is to provide a film removal method allowing separation of a film into a plurality of regions at high yield, a method for fabricating a photoelectric conversion device using the film removal method, a photoelectric conversion device, and a film removal device.

### MEANS FOR SOLVING THE PROBLEMS

A film removal method of the present invention includes the following steps.

A film formed on a substrate is radiated with a first light beam to separate the film into a plurality of regions. Repairing is carried out by removing the film at a removal deficient site remaining between the plurality of regions.

According to the film removal method of the present invention, even if a deficient site is produced in the separation of the film into a plurality of regions by the first light beam, reduction in the process yield can be suppressed since separation is achieved by repairing the deficient site.

Preferably in the repairing step of the film removal method set forth above, the film at the removal deficient site is removed by being radiated with a second light beam. Thus, repairing is carried out by light radiation.

Preferably in the film removal method set forth above, the step of radiating a first light beam is carried out to form a trench pattern in the film, and the width thereof is 10 to 200 µm, preferably 10-100 µm.

Preferably in the film removal method set forth above, the face into which the second light beam enters the substrate is opposite to the face into which the first light beam enters the substrate. Accordingly, the second light beam can reach the film without being affected by a scratch or defect impeding the light path of the first light beam up to the film. Thus, repairing can be carried out more reliably.

Preferably in the film removal method set forth above, repairing is carried out from the side where the substrate film is formed. Accordingly, the effect of a scratch and/or defect at the substrate on the repair can be suppressed.

Preferably in the film removal method set forth above, the second light beam is radiated under a state where the surface of the film is facing downwards. Accordingly, the substance ablated by the second light beam is promptly removed from the proximity of the substrate.

Preferably in the film removal method set forth above, the step of radiating the film at the removal deficient site with the second light beam is carried out by radiating the second light beam to a position shifted by a predetermined distance from the position radiated with the first light beam.

Preferably in the repairing step in the film removal method set forth above, the film at the removal deficient site is removed by mechanical machining from the side where the film of the substrate is formed. Accordingly, repairing can be carried out reliably independent of the optical property of the film.

Preferably in the film removal method set forth above, the substrate has transparency, and the film is radiated with the first light beam through the substrate. This prevents the substance removed from the film surface by the first light beam from impeding the advance of the first light beam.

Preferably in the film removal method set forth above, the location of the removal deficient site is identified before repair. Accordingly, the removal deficient site can be repaired more reliably.

Preferably in the film removal method set forth above, image recognition is carried out at the site where the film is separated in identifying the location of the removal deficient site. This allows the aforementioned identification to be carried out by image recognition,

Preferably in the film removal method set forth above, the film is a conductive film, and the electrical resistance between the plurality of regions is measured for identifying the location of the removal deficient site. This allows the aforementioned identification to be carried out by measurement of electrical resistance.

Preferably in the film removal method set forth above, repairing is carried out on the identified location of the removal deficient site. Accordingly, the removal deficient site can be repaired more reliably.

Preferably in the film removal method set forth above, repairing is carried out in spots on the identified location of the removal deficient site. Accordingly, repairing can be carried out selectively with respect to the removal deficient site. This can suppress the amount of removal in the repairing step, alleviating the effect of such removal on the processing steps.

A method for fabricating a photoelectric conversion device of the present invention includes the following steps.

A film formed on each of a plurality of substrates is radiated with a first light beam to separate the film into a plurality of regions. The electrical resistance between the plurality of regions is measured for each of the plurality of substrates. Based on the measured electrical resistance, at least one defective substrate is identified from the plurality of substrates. For each at least one defective substrate, repairing is carried out by removing the film at the removal deficient site remaining between the plurality of regions. It is desirable to confirm that the defective site has been separated into a plurality of regions by measuring the electrical resistance subsequent to repair.

According to the method for fabricating a photoelectric conversion device of the present invention, even if a deficient site is produced in the separation of a film into a plurality of regions by the first light beam, reduction in yield caused by the defect in film separation can be suppressed since the defective site is repaired.

A photoelectric conversion device of the present invention includes a substrate, and a film formed on the substrate, separated into a plurality of regions by a plurality of separation trenches. The plurality of separation trenches include a first separation trench and a second separation trench. The first separation trench has a first width. The second separation region has a second width larger than the first width, and includes an unprocessed region having a third width greater than or equal to the first width, locally at one side of the second separation trench.

A film removal device of the present invention includes a holding unit, an image recognition unit, and a treatment unit. The holding unit functions to hold a substrate. The image recognition unit functions to carry out image recognition at the surface of the substrate held by the holding unit. The treatment unit performs treatment at an identified location on the substrate held by the holding unit.

According to the film removal device of the present invention, the processing efficiency can be improved since the location to be treated can be identified based on the image recognition result of the image recognition unit.

The image recognition of the substrate surface and treatment on the substrate held by the holding unit, based on the image recognition, can be carried out by one device. Accordingly, the space required for the fabrication step can be reduced.

The film removal device set forth above preferably further includes a resistance measurement unit. The resistance measurement unit functions to measure electrical resistance of an identified site at the substrate held by the holding unit. The aforementioned image recognition is carried out based on the measured electrical resistance. Accordingly, image recognition can be carried out more efficiently.

Preferably in the film removal device set forth above, the treatment unit is a laser emission unit for radiating a laser beam.

Preferably in the film removal device set forth above, the treatment unit functions to carry out mechanical machining.

### EFFECTS OF THE INVENTION

Even in the case where a deficient site is produced in the separation of a film into a plurality of regions by the first light beam in the present invention, reduction in the process yield caused by deficiency in film separation can be suppressed since the deficient site is repaired for separation.

### BRIEF DESCRIPTION OF THE DRAWINGS

Fig. 1 is a plan view schematically representing a configuration of a photoelectric conversion device in a first embodiment of the present invention.
Fig. 2 represents a schematic sectional view, taken along line IIA-IIA (A) and line IIB-IIB (B) of Fig. 1.
Fig. 3 is a flowchart schematically representing a film removal method in the first embodiment of the present invention.
Fig. 4 is a sectional view schematically representing a first step in the film removal method in the first embodiment of the present invention.
Fig. 5 represents a sectional view (A) and a plan view (B), schematically showing a second step in the film removal method in the first embodiment of the present invention.
Fig. 6 is a sectional view schematically representing a third step in the film removal method in the first embodiment of the present invention.
Fig. 7 represents a sectional view (A) schematically showing a fourth step in the film removal method in the first embodiment of the present invention, and a sectional view (B) schematically showing a fourth step in the film removal method according to a first modification in the first embodiment of the present invention.
Fig. 8 is a sectional view schematically representing a fourth step in the film removal method according to a second modification in the first embodiment of the present invention.
Fig. 9 is a sectional view schematically representing a fourth step in the film removal method according to a third modification in the first embodiment of the present invention.
Fig. 10 schematically represents a first step in a method for fabricating a photoelectric conversion device in the first embodiment of the present invention, including a sectional view (A) corresponding to a location along line IIA-IIA, and a sectional view (B) corresponding to a location along line IIB-IIB of Fig. 1.
Fig. 11 schematically represents a second step in a method for fabricating a photoelectric conversion device in the first embodiment of the present invention, including a sectional view (A) corresponding to a location along line IIA-IIA, and a sectional view (B) corresponding to a location along line IIB-IIB of Fig. 1.
Fig. 12 schematically represents a third step in a method for fabricating a photoelectric conversion device in the first embodiment of the present invention, including a sectional view (A) corresponding to a location along line IIA-IIA, and a sectional view (B) corresponding to a location along line IIB-IIB of Fig. 1
Fig. 13 schematically represents a fourth step in a method for fabricating a photoelectric conversion device in the first embodiment of the present invention, including a sectional view (A) corresponding to a location along line IIA-IIA, and a sectional view (B) corresponding to a location along line IIB-IIB of Fig. 1.
Fig. 14 schematically represents a fifth step in a method for fabricating a photoelectric conversion device in the first embodiment of the present invention, including a sectional view (A) corresponding to a location along line IIA-IIA, and a sectional view (B) corresponding to a location along line IIB-IIB of Fig. 1.
Fig. 15 schematically represents a sixth step in a method for fabricating a photoelectric conversion device in the first embodiment of the present invention, including a sectional view (A) corresponding to a location along line IIA-IIA, and a sectional view (B) corresponding to a location along line IIB-IIB of Fig. 1.
Fig. 16 schematically represents a seventh step in a method for fabricating a photoelectric conversion device in the first embodiment of the present invention, including a sectional view (A) corresponding to a location along line IIA-IIA, and a sectional view (B) corresponding to a location along line IIB-IIB of Fig. 1.
Fig. 17 schematically represents an eighth step in a method for fabricating a photoelectric conversion device in the first embodiment of the present invention, including a sectional view (A) corresponding to a location along line IIA-IIA, and a sectional view (B) corresponding to a location along line IIB-IIB of Fig. 1.
Fig. 18 is a sectional view corresponding to a location taken along line IIB-IIB of Fig. 1, schematically representing a repairing step carried out subsequent to the second step in the method for fabricating a photoelectric conversion device in the first embodiment of the present invention.
Fig. 19 is a sectional view corresponding to a location taken along line IIB-IIB of Fig. 1, schematically representing a repairing step carried out subsequent to the sixth step in the method for fabricating a photoelectric conversion device in the first embodiment of the present invention.
Fig. 20 is a perspective view schematically representing a configuration of a film removal device in a second embodiment of the present invention.
Fig. 21 is a block diagram representing a configuration of respective functions realized by the film removal device of Fig. 20.
Fig. 22 is a flowchart schematically representing a film removal method using the film removal device in the second embodiment of the present invention.
Fig. 23 is a flowchart schematically representing a film removal method employing a film removal device according to a modification in the second embodiment of the present invention.
Fig. 24 is a partial plan view schematically representing a configuration of a photoelectric conversion device in a fourth embodiment of the present invention.
Fig. 25 is a partial plan view schematically representing a position where a repairing step is carried out according to a method for fabricating a photoelectric conversion device in the fourth embodiment of the present invention.
Fig. 26 is a partial plan view schematically showing a configuration of a photoelectric conversion device according to a first modification in the fourth embodiment of the present invention
Fig. 27 is a partial plan view schematically showing a configuration of a photoelectric conversion device according to a second modification in the fourth embodiment of the present invention.

### MODES FOR CARRYING OUT THE INVENTION

Embodiments of the present invention will be described hereinafter based on the drawings.

### (First Embodiment)

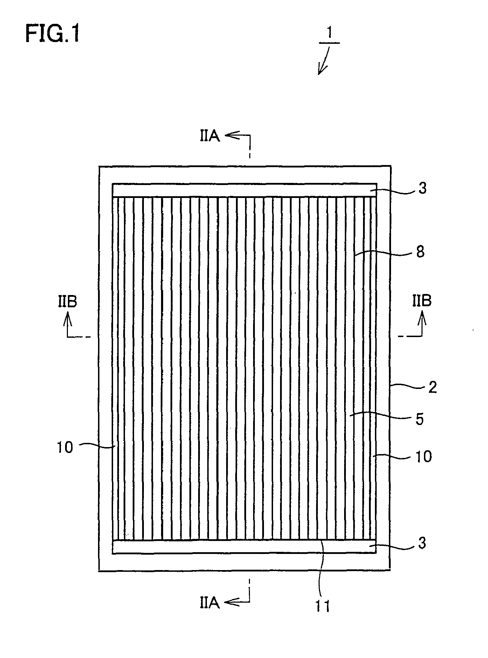

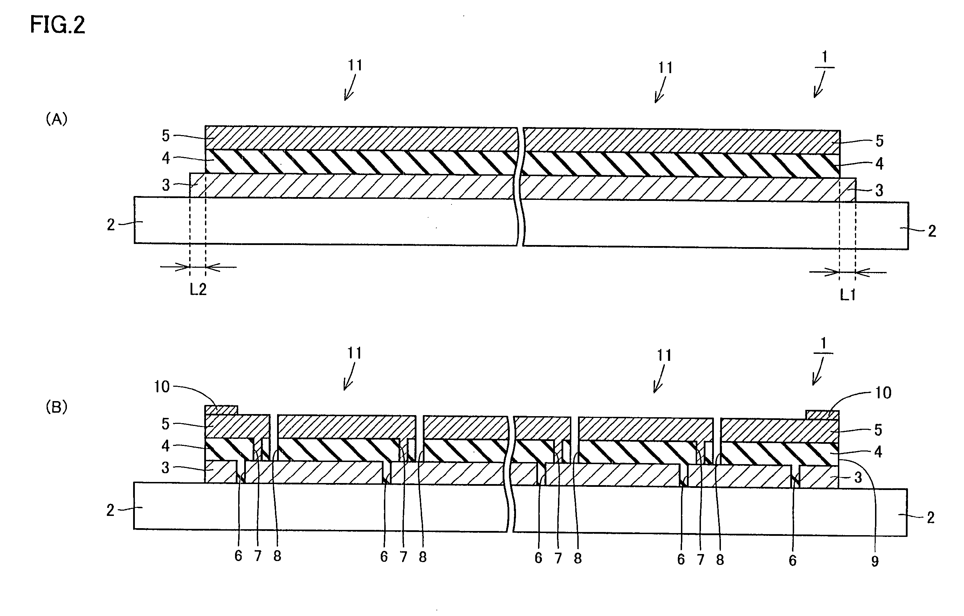

Fig. 1 is a plan view schematically representing a configuration of a photoelectric conversion device in a first embodiment of the present invention. In Fig. 2, (A) and (B) are schematic sectional views taken along line IIA-IIA and line IIB-IIB, respectively, of Fig. 1. Referring to Figs. 1 and 2, a thin film solar cell 1 identified as a photoelectric conversion device of the present embodiment includes a transparent insulation substrate 2, a transparent electrode layer 3, a semiconductor photoelectric conversion layer 4, a back electrode layer 5, and an electrode 10.

Transparent insulation substrate 2 has transparency. On transparent insulation substrate 2 are stacked transparent electrode layer 3, semiconductor photoelectric conversion layer 4, and back electrode layer 5 in the cited order.

Transparent electrode layer 3 is a conductive film, separated into a plurality of regions by a first separation trench 6. First separation trench 6 is filled with semiconductor photoelectric conversion layer 4.

Back electrode layer 5 is a conductive film. Back electrode layer 5 and semiconductor photoelectric conversion layer 4 are separated into a plurality of cell regions 11 by a second separation trench 8.

A contact line 7 that is a through portion is formed in semiconductor photoelectric conversion layer 4. Contact line 7 is filled with back electrode layer 5, and connects adjacent cell regions 11 electrically in series. An electrode 10 is provided on back electrode layer 5 as a terminal of such cell regions 11 connected in series.

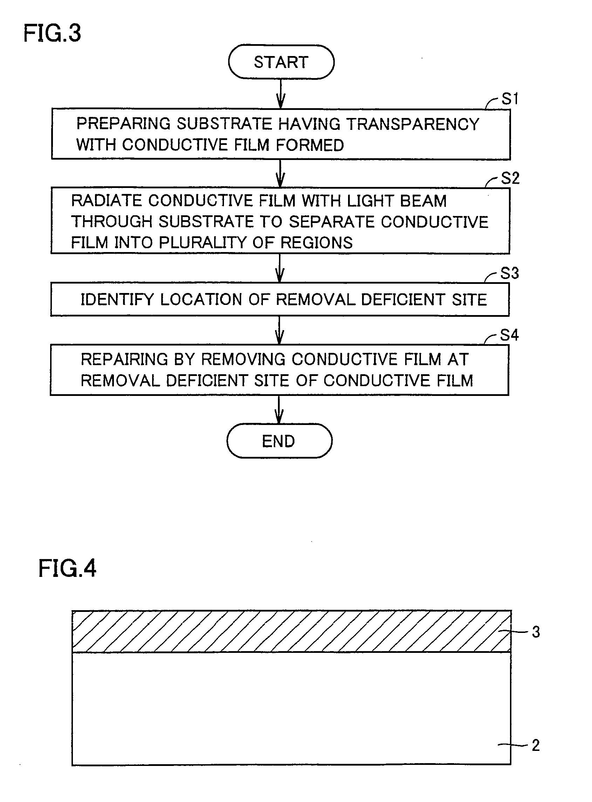

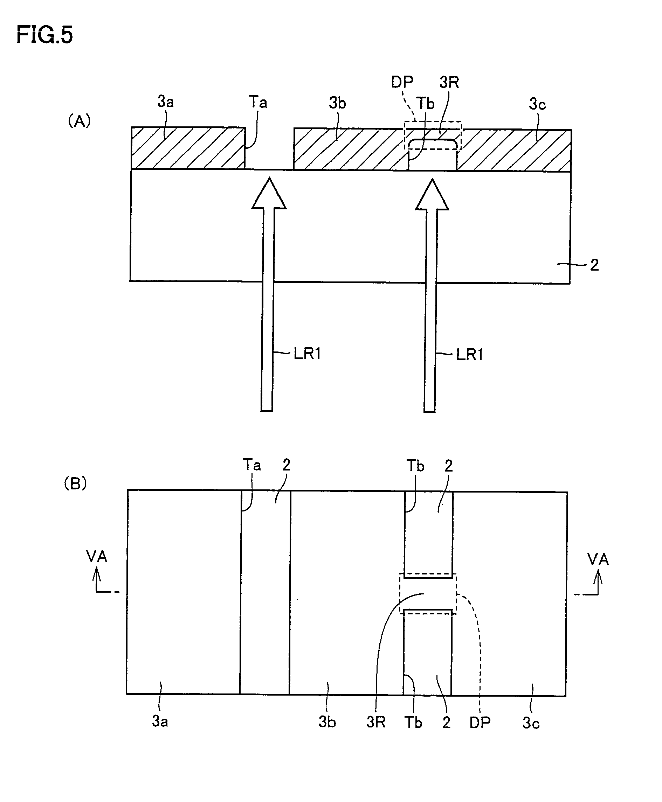

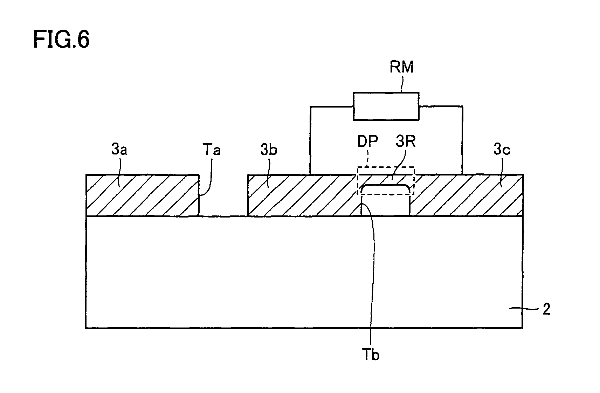

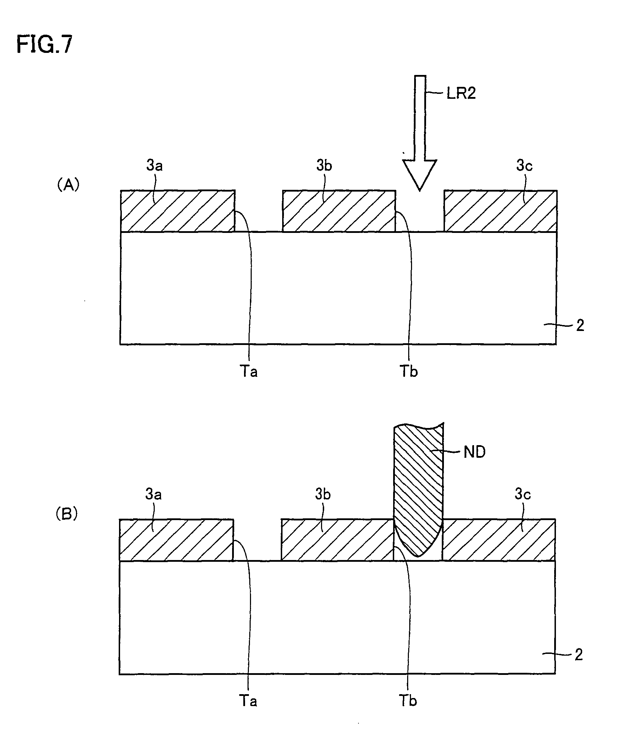

A film removal method that can be applied to a method for fabricating a thin film solar cell 1 (Figs. 1 and 2) of the present embodiment will be described based on an example of separating transparent electrode layer 3. Fig. 3 is a flowchart schematically representing the film removal method in the first embodiment of the present invention. Fig. 4 is a sectional view schematically representing a first step in the film removal method in the first embodiment of the present invention. In Fig. 5, (A) and (B) are a sectional view and plan view, respectively, schematically representing a second step in the film removal method in the first embodiment of the present invention. Fig. 6 is a sectional view schematically representing a third step in the film removal method in the first embodiment of the present invention. In Fig. 7, (A) and (B) are sectional views schematically representing a fourth step in the film removal method according to the first embodiment of the present invention and a modification thereof.

Referring to Fig. 4, a transparent insulation substrate 2 having transparency, including transparent electrode layer 3 formed thereon, is prepared (step S1: Fig. 3).

Referring to Fig. 5 (A) and (B), a laser beam LR1 (first laser beam) is selectively radiated to transparent electrode layer 3 (film) (Fig. 4) formed on transparent insulation substrate 2 (substrate) through transparent insulation substrate 2 in order to separate transparent electrode layer 3 (Fig. 4) into a plurality of regions (step S2: Fig. 3). By the radiation effecting laser scribing, separation trenches Ta and Tb are formed, separating transparent electrode layer 3 (Fig. 4) into transparent electrode layers 3a-3c.

Instead of radiating laser beam L1 to transparent electrode layer 3 through transparent insulation substrate 2, transparent electrode layer 3 may be directly radiated without the passage of the laser beam through transparent insulation substrate 2. Specifically, laser beam LR1 may be radiated from above, instead from below in Fig. 5(A).

In the case where there is a scratch or defect in transparent insulation substrate 2 in laser scribing, a site where transparent electrode layer 3 that should be removed (Fig. 4) remains, i.e. a removal deficient site DP, may be produced caused by the transmittance of laser beam LR1 through transparent insulation substrate 2 being impeded. Residue transparent electrode layer 3R that is transparent electrode layer 3 remaining at removal deficient site DP will cause shorting between transparent electrode layers 3b and 3c where electrical insulation should be maintained.

Referring to Fig. 6, the resistance between one pair of adjacent transparent electrode layers, among transparent electrode layers 3a - 3c, is measured to identify the presence of a removal deficient site DP. During this resistance measurement, a resistance meter RM is connected across the aforementioned pair of transparent electrode layers. A determination is made whether there is a removal deficient site DP or not depending upon the degree of the measured resistance values. When there is a removal deficient site DP, separation trench Tb where removal deficient site DP is present is identified. Thus, the location of removal deficient site DP is identified (step S3: Fig. 3).

Preferably, image recognition is carried out at separation trench Tb (Fig. 5 (B)) that has been determined as including removal deficient site DP. Accordingly, the location of removal deficient site DP in separation trench Tb can be identified, allowing identification of the position of removal deficient site DP in more detail.

Referring to Fig. 7 (A) and (B), repairing is carried out on removal deficient site DP (Fig. 6) (step S4: Fig. 3). Specifically, residue transparent electrode layer 3R (Fig. 6) is removed to ensure electrical insulation between transparent electrode layers 3a-3c, i.e. separation trenches Ta and Tb.

As a way of repairing, the process of ablating residue transparent electrode layer 3R by radiating a laser beam LR2 (second light beam) from the side of transparent insulation substrate 2 where transparent electrode layer 3 (Fig. 4) is formed (the upper side in the drawing), as shown in Fig. 7 (A) can be employed. Alternatively, mechanical machining to remove residue transparent electrode layer 3R can be employed using a needle ND, for example, as shown in Fig. 7 (B).

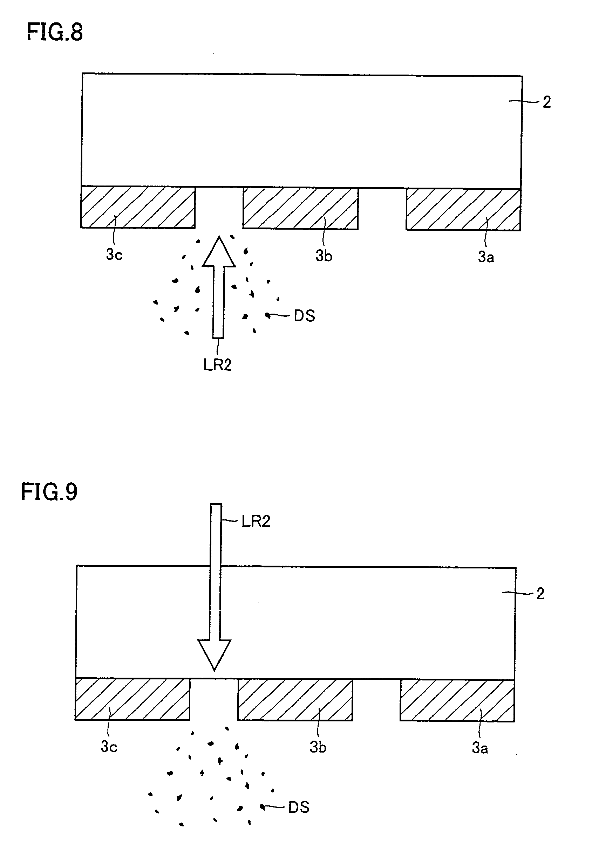

The repairing using laser beam LR2 (Fig. 7 (A)) may be carried out with the surface of transparent electrode layers 3a-3c facing downwards, as shown in Fig. 8. Further, the repairing may be carried out by radiating laser beam LR2 through transparent insulation substrate 2, as shown in Fig. 9.

Moreover, laser beams LR1 and LR2 may have properties identical to each other, and may be radiated from the same laser emission unit.

In the method for fabricating thin film solar cell 1 (Fig. 1 and Fig. 2), the aforementioned repairing may be applied to back electrode layer 5 or the like besides transparent electrode layer 3. A specific manner of repairing will be described hereinafter in accordance with the method for fabricating thin film solar cell 1.

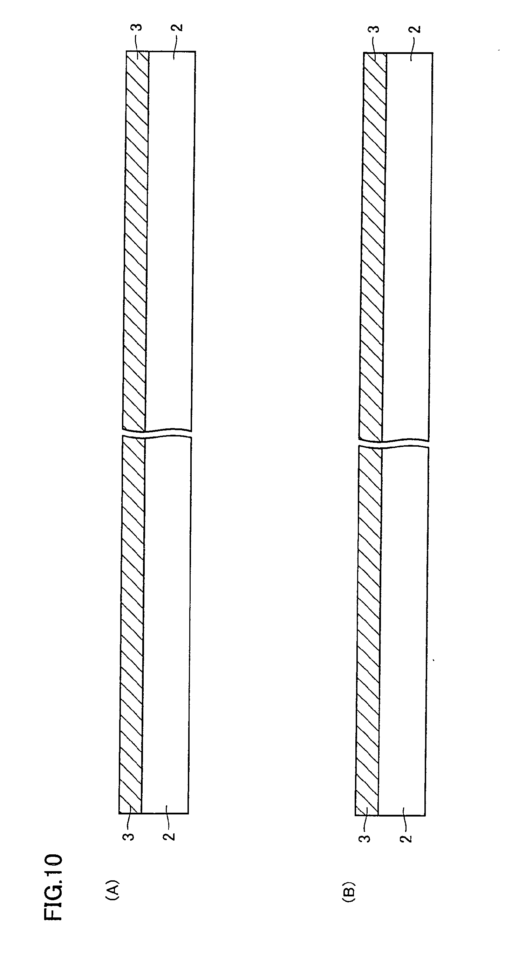

Figs. 10-17 schematically represent the first to eighth steps in the processing sequence of the method for fabricating a photoelectric conversion device in the first embodiment of the present invention. Fig. 1 includes sectional views (A) and (B) corresponding to the position along lines IIA-IIA and IIB-IIB, respectively, of Fig. 1.

Referring to Fig. 10 (A) and (B), transparent insulation substrate 2 having transparent electrode layer 3 formed is prepared as the step corresponding to step S 1 (Fig. 3). Transparent insulation substrate 2 is, for example, a glass substrate. For the material of transparent electrode layer 3, SnO₂ (tin oxide), ITO (indium tin oxide) or ZnO (zinc oxide), for example, can be employed.

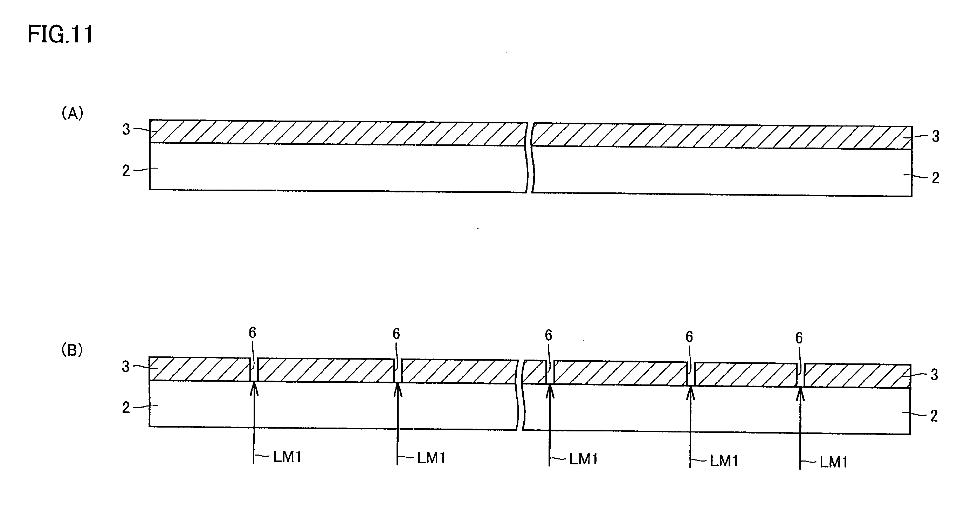

Referring mainly to Fig. 11 (A) and (B), transparent electrode layer 3 is radiated with a laser beam LM1 (first laser beam) through transparent insulation substrate 2 as the step corresponding to step S2 (Fig. 3). The wavelength of laser beam LM1 is selected such that light absorption occurs mainly at transparent electrode layer 3, and is 1064 nm, for example. By laser scribing through this laser beam LM1, a first separation trench 6 separating transparent electrode layer 3 into a plurality of regions is formed.

Instead of radiating laser beam LM1 to transparent electrode layer 3 through transparent insulation substrate 2, transparent electrode layer 3 may be radiated directly without the passage of the laser beam through transparent insulation substrate 2. In other words, laser beam LM1 may be radiated from above, instead of from below as shown in Fig. 11 (B).

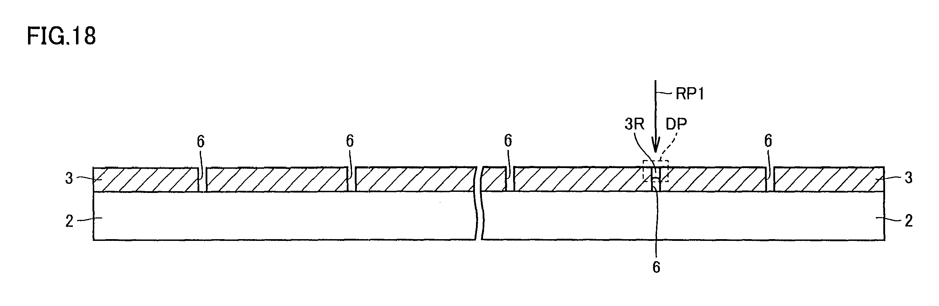

By steps S3 and S4 (Fig. 3), electrical insulation of first separation trench 6 is ensured. Specifically, transparent electrode layer 3 remaining at removal deficient site DP, i.e. residue transparent electrode layer 3R, is removed by repairing RP1, as shown in Fig. 18. Repairing RP1 is carried out by a laser beam (second laser beam) having a wavelength similar to that of laser beam LM1, for example.

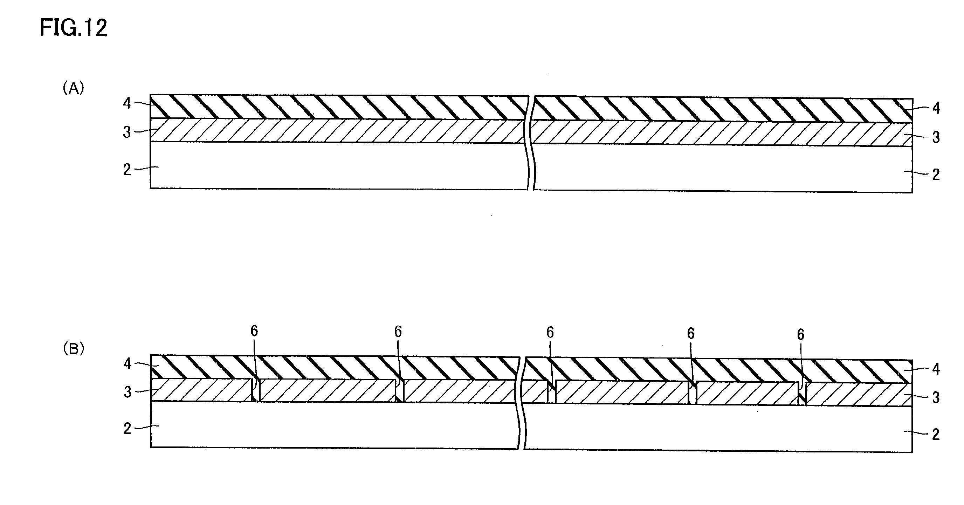

Referring to Fig. 12 (A) and (B), semiconductor photoelectric conversion layer 4 covering transparent electrode layer 3 so as to fill first separation trench 6 is formed. Semiconductor photoelectric conversion layer 4 has a configuration in which a p layer, i layer, and n layer formed of amorphous silicon thin films are sequentially stacked, and the thickness thereof is greater than or equal to 200 nm and less than or equal to 5 µm.

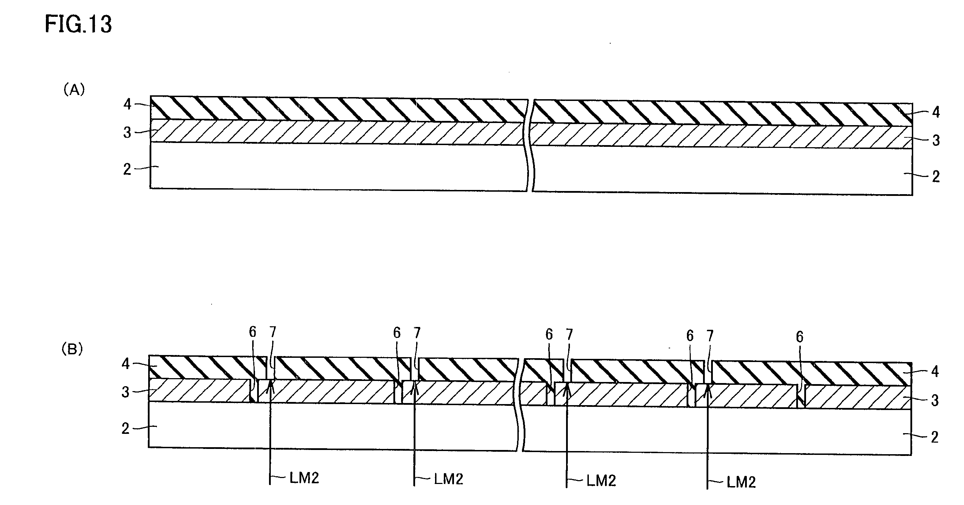

Referring to Fig. 13 (A) and (B), laser beam LM2 is radiated to transparent electrode layer 3 and semiconductor photoelectric conversion layer 4 through transparent insulation substrate 2. The wavelength of laser beam LM2 is selected such that light absorption occurs mainly at semiconductor photoelectric conversion layer 4, and is 532 nm, for example. Accordingly, contact line 7 is formed by ablating a portion of semiconductor photoelectric conversion layer 4.

Instead of radiating laser beam LM2 to semiconductor photoelectric conversion layer 4 through transparent insulation substrate 2, semiconductor photoelectric conversion layer 4 may be directly radiated without the passage of the laser beam through transparent insulation substrate 2. In other words, laser beam LM2 may be radiated from above, instead of from below as in Fig. 13 (B).

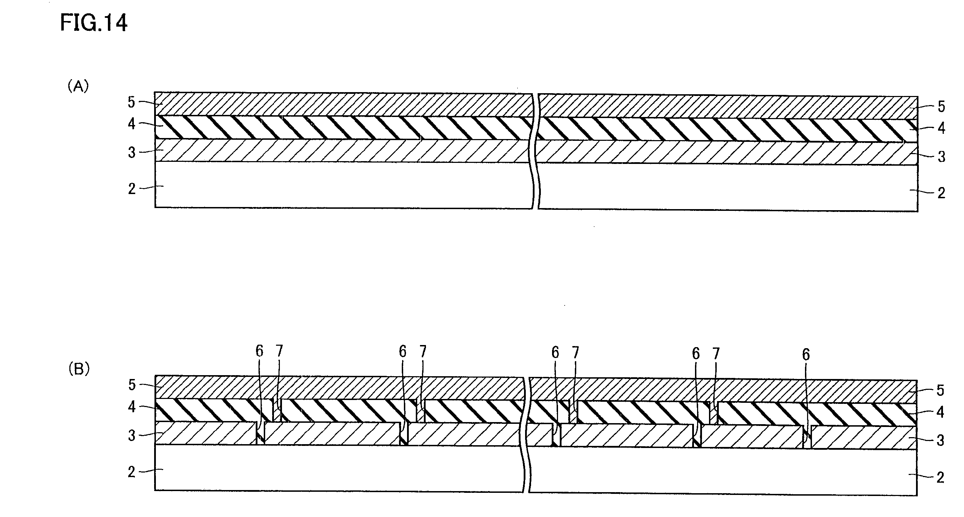

Referring mainly to Fig. 14 (A) and (B), a back electrode layer 5 is formed, covering semiconductor photoelectric conversion layer 4 so as to fill contact line 7, as the step corresponding to step S1 (Fig. 3). Back electrode layer 5 is a stacked body of a ZnO layer and an Ag (silver) layer, for example.

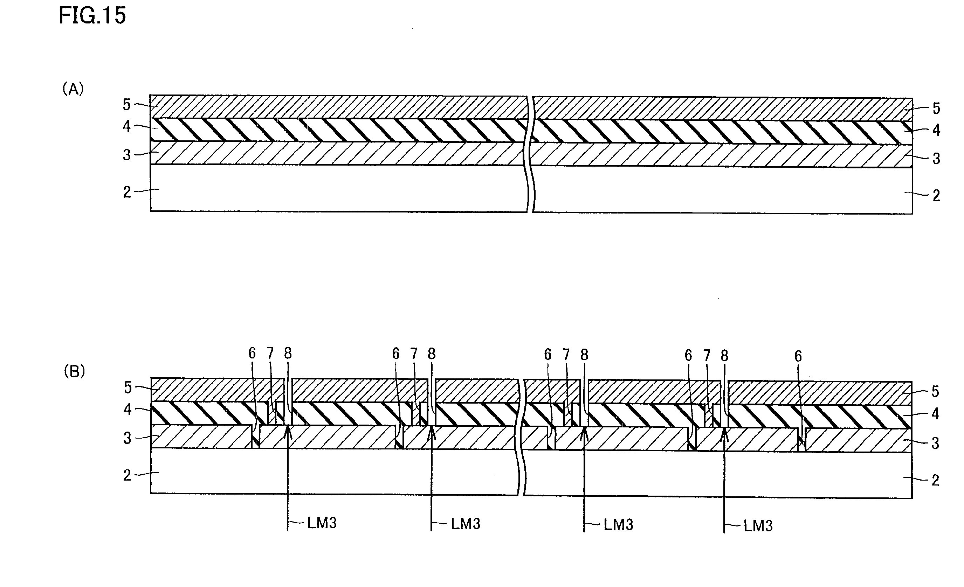

Referring mainly to Fig. 15 (A) and (B), laser beam LM3 (first laser beam) is radiated to transparent electrode layer 3, semiconductor photoelectric conversion layer 4, and back electrode layer 5 through transparent insulation substrate 2 as the step corresponding to step S2 (Fig. 3). The wavelength of laser beam LM3 is selected such that light absorption occurs mainly at semiconductor photoelectric conversion layer 4, and is 532 nm, for example. Accordingly, a second separation trench 8 is formed by ablating semiconductor photoelectric conversion layer 4 and back electrode layer 5 partially.

Laser beam LM3 is preferably radiated to semiconductor photoelectric conversion layer 4 through transparent insulation substrate 2, as described above. In other words, laser beam LM3 is preferably radiated from below in Fig. 15 (B). This is because sufficient ablation cannot be effected readily since the ratio of laser beam LM3, when radiated from above in Fig. 15 (B), reaching semiconductor photoelectric conversion layer 4 is reduced due to reflectance by back electrode layer 5.

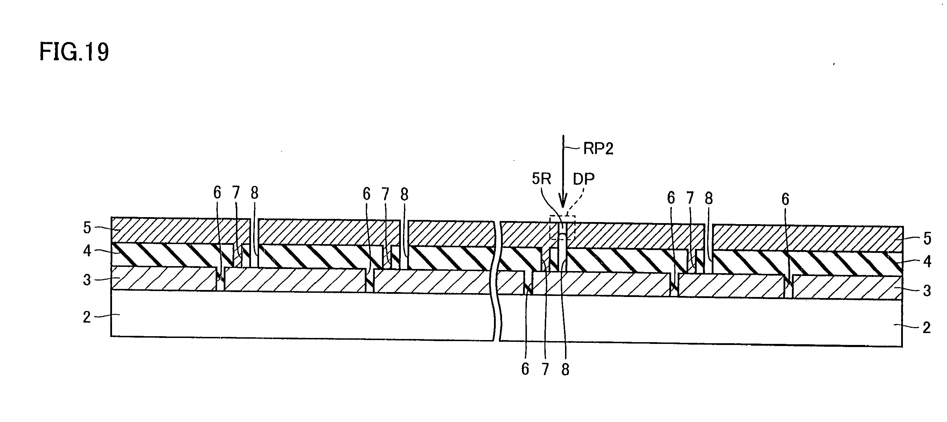

Then, steps S3 and S4 (Fig. 3) are carried out to ensure electrical insulation of second separation trench 8. In other words, back electrode layer 5 remaining at the removal deficient site, i.e. residue back electrode layer 5R, is removed by repairing RP2, as shown in Fig. 19.

Preferably, repairing RP2 is carried out by mechanical machining (Fig. 7 (B)). Since repairing RP2 is carried out not by light, but by mechanical machining, repairing can be carried out reliably even if back electrode layer 5 has high light reflectance. Mechanical machining will not cause crystal growth of semiconductor photoelectric conversion layer 4, unlike laser processing that is associated with temperature increase of the workpiece. Accordingly, increase in leakage current caused by increase of the crystal size of semiconductor photoelectric conversion layer 4 can be avoided.

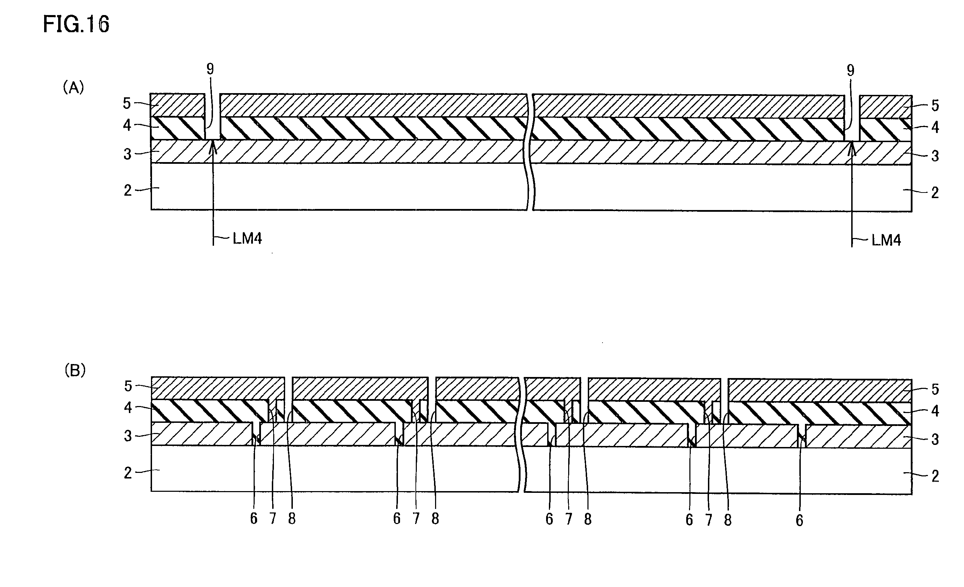

Referring mainly to Fig. 16 (A) and (B), a laser beam LM4 (first laser beam) is radiated to transparent electrode layer 3, semiconductor photoelectric conversion layer 4, and back electrode layer 5 through transparent insulation substrate 2, as a step corresponding to step S2 (Fig. 3). The wavelength of laser beam LM4 is selected such that light absorption occurs mainly at semiconductor photoelectric conversion layer 4, and is 532 nm, for example. Accordingly, an edge trench 9 is formed adjacent to either end of second separation trench 8 in the longitudinal direction (left and right sides in Fig. 16 (A)) by ablation of a portion of semiconductor photoelectric conversion layer 4 and back electrode layer 5. By subsequent steps S3 and S4 (Fig. 3), electrical insulation of edge trench 9 is ensured.

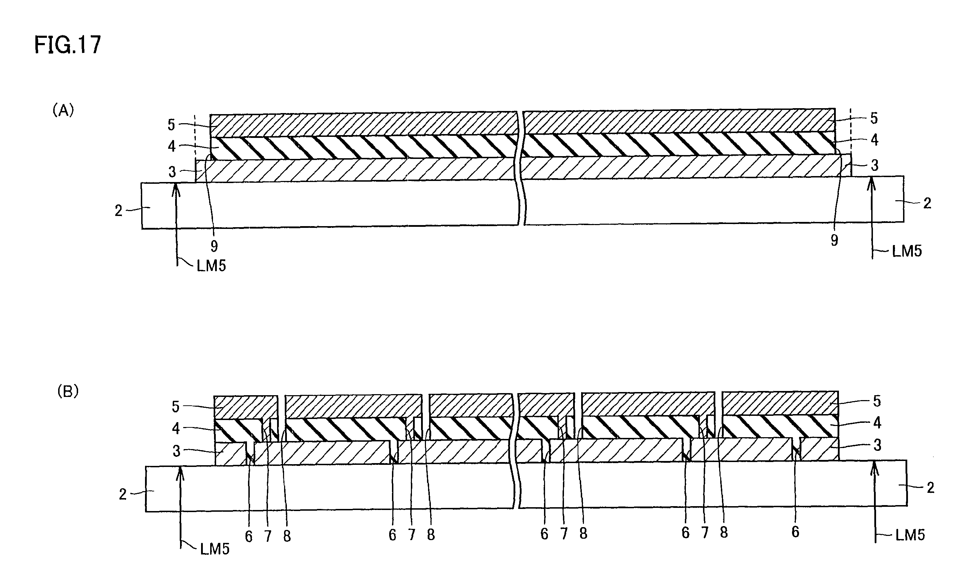

Referring to Fig. 17 (A) and (B), a laser beam LM5 is radiated to the region at the outer side of edge trench 9 (the outer side of the broken line in Fig. 17 (A)), and the outer side region along the extending direction of second separation trench 8 (left and right sides in Fig. 17 (B)). The wavelength of laser beam LM5 is selected such that light absorption occurs mainly at transparent electrode layer 3, and is 1064 nm, for example. Accordingly, transparent electrode layer 3, semiconductor photoelectric conversion layer 4, and back electrode layer 5 are ablated partially.

Referring to Fig. 2 (A) and (B), an electrode 10 extending in a direction identical to the extending direction of second separation trench 8 is formed on the surface of back electrode layer 5 at either side in a direction orthogonal to the extending direction of second separation trench 8.

Thus, thin film solar cell 1 identified as a photoelectric conversion device of the present embodiment is obtained.

According to the present embodiment, reduction in the process yield can be suppressed since removal deficient site DP is repaired even in the case where removal deficient site DP is produced in separating transparent electrode layer 3 (Fig. 4) into transparent electrode layers 3a-3c (Fig. 5 (A)) by laser beam LR1 (Fig. 5 (A)) through transparent insulation substrate 2.

Although the above description is based on thin film solar cell 1 obtained through a repairing step, the final product in mass production may be a mixture of a thin film solar cell 1 obtained through a repairing step and a thin film solar cell 1 obtained without a repairing step. The steps set forth below may be carried out as an example of separation of transparent electrode layer 3.

In order to separate transparent electrode layer 3 (Fig. 4) formed on each of a plurality of transparent insulation substrates 2 into a plurality of regions, laser beam LR1 (Fig. 5 (A)) is radiated to transparent electrode layer 3. Then, the electrical resistance between the plurality of regions is measured for each of transparent insulation substrates 2 (Fig. 6). Based on such measured electrical resistance, at least one defective substrate is identified from transparent insulation substrates 2. For each at least one defective substrate, repairing is carried out by removing the transparent electrode layer at removal deficient site DP remaining between the plurality of regions. Repairing does not have to be carried out on a substrate that is not defective.

### (Second Embodiment)

In the present embodiment, a film removal device that can be used in steps S3 and S4 (Fig. 3) in the above-described first embodiment and a method of using the film removal device will be described hereinafter.

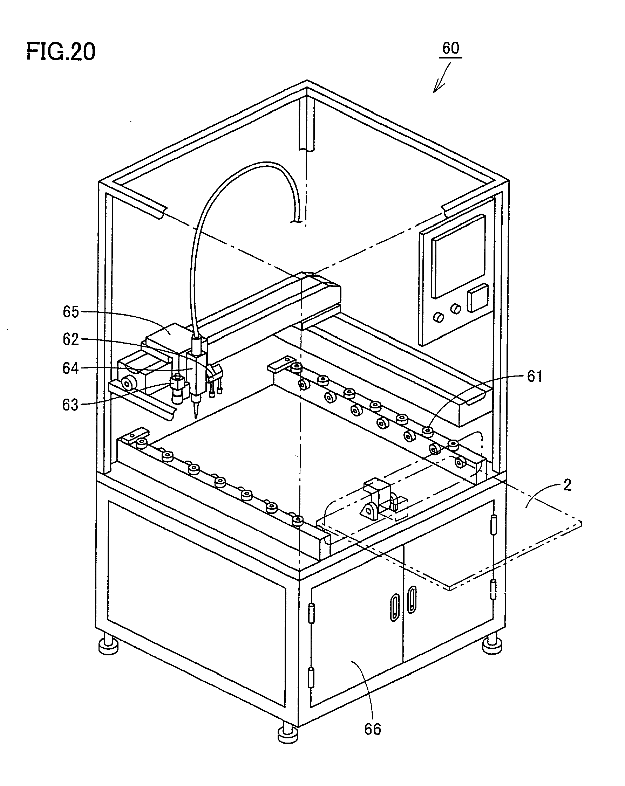

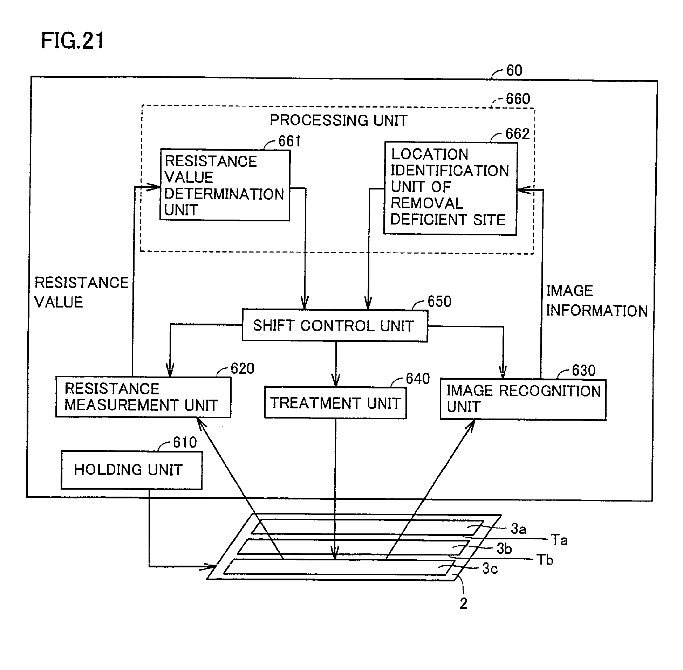

Fig. 20 is a perspective view schematically representing a configuration of a film removal device in a second embodiment of the present invention. Fig. 21 is a block diagram representing a configuration of respective functions realized by the film removal device of Fig. 20.

Referring to Figs. 20 and 21, a film removal device 60 of the present embodiment includes a support roller 61 (holding unit 610), a probe 62 (resistance measurement unit 620), a CCD camera 63 (image recognition unit 630), a laser emission unit 64 (treatment unit 640), and an X-Y robot 65 (shift control unit).

Holding unit 610 functions to hold transparent insulation substrate 2.

Resistance measurement unit 620 functions to measure the electrical resistance at a specific site of transparent insulation substrate 2 held by holding unit 610.

Resistance value determination unit 661 functions to identify a separation trench where a removal deficient site is present (for example, separation trench Tb), based on a resistance value obtained by resistance measurement unit 620.

Image recognition unit 630 functions to carry out image recognition at the surface of transparent insulation substrate 2 held by holding unit 610 based on the electrical resistance measured by resistance measurement unit 620.

Location identification unit 662 for a removal deficient site functions to identify where in the separation trench (for example, separation trench Tb) a removal deficient site is present, based on the image information obtained by image recognition unit 630.

Treatment unit 640 functions to carry out treatment at a specified site on transparent insulation substrate 2 held by holding unit 610, based on the image recognition by image recognition unit 630.

Shift control unit 650 functions to displace resistance measurement unit 620, image recognition unit 630, and treatment unit 640, based on an instruction from processing unit 660.

Processing unit 660 functions to control shift control unit 650 based on the determination result from resistance value determination unit 661 and the identification result from location identification unit 662.

Since elements of the configuration other than those set forth above are substantially similar to those of the above-described first embodiment, the same or corresponding elements have the same reference characters allotted, and description thereof will not be repeated.

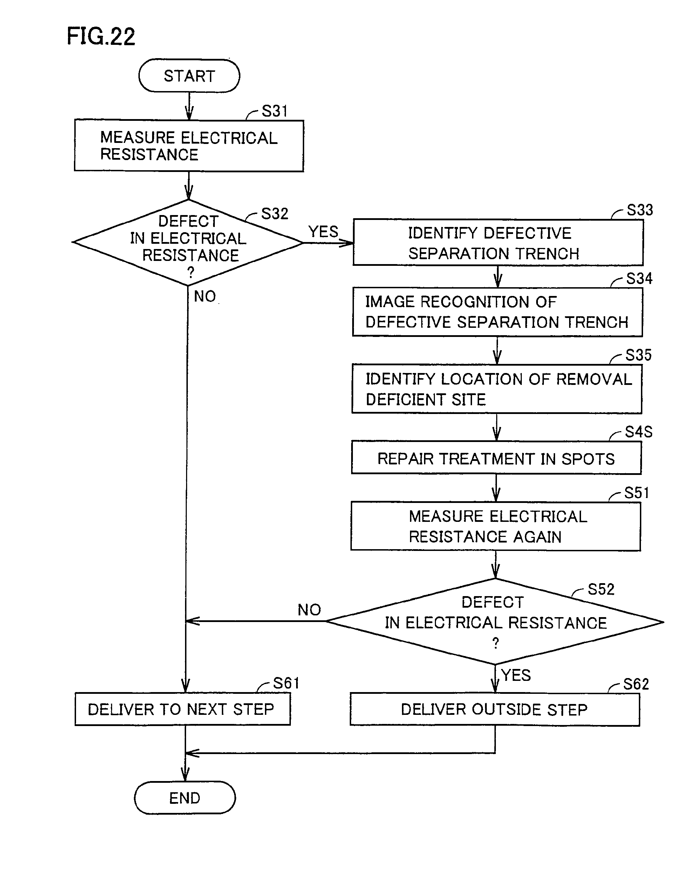

A method of using film removal device 60 will be described hereinafter. Fig. 22 is a flowchart schematically representing a film removal method using the film removal device in the second embodiment of the present invention.

Referring to Figs. 20-22, the electrical resistance is measured by resistance measurement unit 620 at step S31. Specifically, by using a probe 62 against each of transparent electrode layers 3b and 3c, for example, the electrical resistance of separation trench Tb is measured. The value of the electrical resistance of each separation trench is transmitted to resistance value determination unit 661.

At step S32, resistance value determination unit 661 determines whether there is a defect in the electrical resistance. For example, a determination of a defect in the electrical resistance is made when there is a value lower than a threshold value among the resistance values transmitted from resistance measurement unit 620. When a determination is made that there is no defect, step S61 is executed. In contrast, when a determination is made that there is a defect, step S33 is executed.

At step S33, resistance value determination unit 661 identifies the defective separation trench. For example, a separation trench having a resistance value lower than the threshold value is detected.

At step S34, image recognition of the defective separation trench is made by image recognition unit 630. For example, when separation trench Tb is identified as being defective at step S33, CCD camera 630 is moved along separation trench Tb by X-Y robot 65 to carry out image recognition of separation trench Tb.

At step S35, the location of a removal deficient site in the separation trench is identified based on the image recognition of the defective separation trench through location identification unit 662.

At step S4S, repair treatment is carried out in spots in accordance with the location identified at step S35. Specifically, the position of treatment unit 640 is controlled by the movement of shift control unit 650 to the location identified by location identification unit 662 while treatment unit 640 carries out repair treatment. The repair treatment is carried out by laser processing through laser emission unit 64 (Fig. 20) including a fiber laser. Mechanical machining may be carried out instead of laser processing. In this case, a device having a needle ND (Fig. 7) mounted at the position of laser emission unit 64 (Fig. 20) can be employed.

At step S51, the electrical resistance of the separation trench identified at step S33 is measured again. Specifically, the electrical resistance of the separation trench identified by resistance value determination unit 661 is measured again by resistance measurement unit 620. The value of the re-measured electrical resistance is transmitted to resistance value determination unit 661.

At step S52, resistance value determination unit 661 determines again whether there is a defect in the electrical resistance. When a determination is made that there is no defect, step S61 is executed.

At step S61, transparent insulation substrate 2 is delivered to the next step as a good product.

In the case where a determination is made that there is a defect at step S52, transparent insulation substrate 2 is delivered at step S62 outside the fabrication step as an unacceptable product.

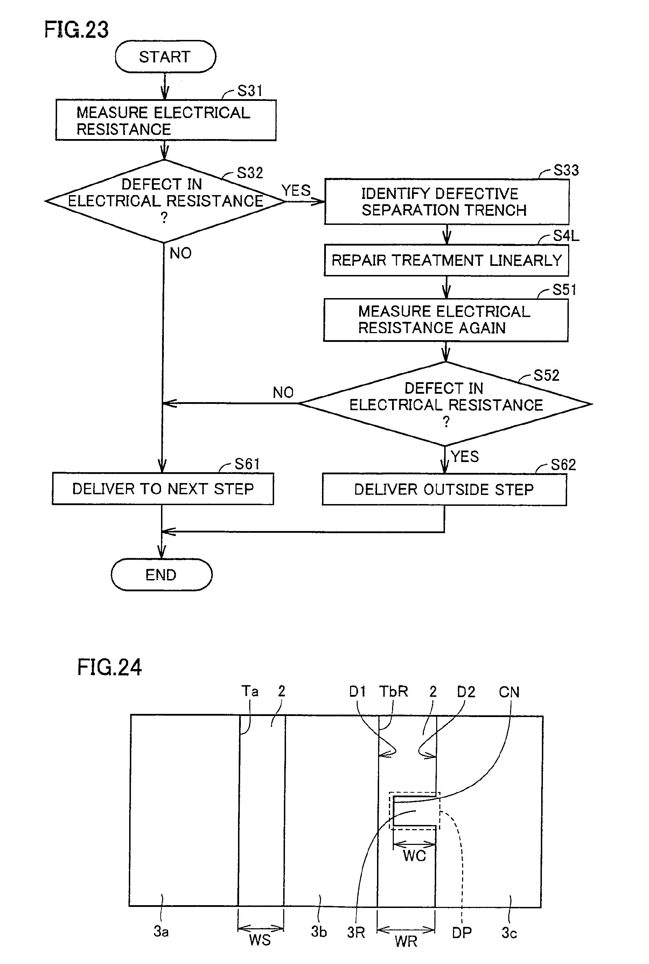

Fig. 23 is a flowchart schematically representing a film removal method employing a film removal device according to a modification in the second embodiment of the present invention.

Referring to Fig. 23, although a separation trench having a deficient site is identified in the present modification, as described above, the location of where in the separation trench the deficient site is present is not identified. Therefore, steps S34 and S35 (Fig. 22) are not executed.

At step S4L, repair treatment is carried out in a linear manner along the entirety of the separation trench identified at step S33. Specifically, the position of treatment unit 640 is controlled by the movement of shift control unit 650 along the entirety of the identified separation trench while treatment unit 640 carries out repairing in a linear manner.

According to film removal device 60 of the present embodiment, the location where repair is required can be identified based on the resistance value and image information through processing unit 660 (Fig. 21). Therefore, the efficiency in repairing can be improved.

As shown in Fig. 20, probe 62 (resistance measurement unit), CCD camera 63 (image recognition unit), and laser emission unit 64 (treatment unit) are accommodated in one device. Therefore, the electrical resistance measurement, image recognition at a substrate surface based on the electrical resistance, and laser beam radiation for treatment based on the image recognition can be carried out by one film removal device 60.

Further, probe 62 (resistance measurement unit), CCD camera 63 (image recognition unit), and laser emission unit 64 (treatment unit) have their position controlled by one X-Y robot 65 (position control unit). Therefore, it is not necessary to provide a plurality of position control units.

Although a glass substrate is indicated as transparent insulation substrate 2 in the description above, the present invention is not limited thereto. For example, a flexible substrate such as an acryl substrate can be used.

### (Third Embodiment)

Another embodiment of step S4 of Fig. 3 in the first embodiment set forth above will be described in the present embodiment.

Thin film solar cell 1 identified as a photoelectric conversion device of the present embodiment shown in Figs. 1 and 2 includes a transparent insulation substrate 2, a transparent electrode layer 3, a semiconductor photoelectric conversion layer 4, a back electrode layer 5, and an electrode 10.

Transparent insulation substrate 2 has transparency. On transparent insulation substrate 2 are stacked transparent electrode layer 3, semiconductor photoelectric conversion layer 4, and back electrode layer 5 in the cited order.

Transparent electrode layer 3 is a conductive film, separated into a plurality of regions by a first separation trench 6. First separation trench 6 is filled with semiconductor photoelectric conversion layer 4.

Back electrode layer 5 is a conductive film. Back electrode layer 5 and semiconductor photoelectric conversion layer 4 are separated into a plurality of cell regions 11 by a second separation trench 8.

A contact line 7 that is a through portion is formed in semiconductor photoelectric conversion layer 4. Contact line 7 is filled with back electrode layer 5, and connects adjacent cell regions 11 electrically in series. An electrode 10 is provided on back electrode layer 5 as a terminal of such cell regions 11 connected in series.

A film removal method that can be applied to a method for fabricating a thin film solar cell 1 of the present embodiment will be described based on an example of separating transparent electrode layer 3.

Referring to Fig. 4, a transparent insulation substrate 2 having transparency, including transparent electrode layer 3 formed thereon is prepared (step S1: Fig. 3).

Referring to Fig. 5 (A) and (B), a laser beam LR1 (first laser beam) is selectively radiated to transparent electrode layer 3 (Fig. 4) formed on transparent insulation substrate 2 through transparent insulation substrate 2 in order to separate transparent electrode layer 3 (Fig. 4) into a plurality of regions (step S2: Fig. 3). By the radiation effecting laser scribing, separation trenches Ta and Tb are formed, separating transparent electrode layer 3 (Fig. 4) into transparent electrode layers 3a-3c.

In the case where there is a scratch or defect in transparent insulation substrate 2 in laser scribing, a site where transparent electrode layer 3 that should be removed (Fig. 4) remains, i.e. a removal deficient site DP, may be produced caused by the transmittance of laser beam LR1 through transparent insulation substrate 2 being impeded. Residue transparent electrode layer 3R that is transparent electrode layer 3 remaining at removal deficient site DP will cause shorting between transparent electrode layers 3b and 3c where electrical insulation should be maintained.

Referring to Fig. 6, the resistance between one pair of adjacent transparent electrode layers, among transparent electrode layers 3a - 3c, is measured to identify the presence of a removal deficient site DP. During this resistance measurement, a resistance meter RM is connected across the aforementioned pair of transparent electrode layers. A determination is made whether there is a removal deficient site DP or not depending upon the degree of the measured resistance values. When there is a removal deficient site DP, separation trench Tb where removal deficient site DP is present is identified. Thus, the location of removal deficient site DP is identified (step S3: Fig. 3).

Preferably, image recognition is carried out at separation trench Tb (Fig. 5 (B)) determined to include removal deficient site DP. Accordingly, the location of removal deficient site DP in separation trench Tb can be identified, allowing identification of the position of removal deficient site DP in more detail.

Then, repairing is carried out on removal deficient site DP (step S4: Fig. 3). Specifically, residue transparent electrode layer 3R is removed to ensure electrical insulation between transparent electrode layers 3a-3c, i.e. separation trenches Ta and Tb.

As a way of repair, ablation of residue transparent electrode layer 3R can be employed by directing laser beam LR2 (second light beam) from the substrate side of transparent insulation substrate 2 through transparent insulation substrate 2, as shown in Fig. 9, after the defect adhering to transparent insulation substrate 2 or transparent electrode layer 3 is removed by substrate cleaning or rubbing. Alternatively, the approach of shifting the position receiving the emitting laser beam LR2 (second light beam), and directing laser beam L2 (second light beam) from the side of transparent insulation substrate 2, or from the side of transparent insulation substrate 2 where transparent electrode layer 3 (Fig. 4) is formed, may be employed. Accordingly, separation trench Tb can be connected, avoiding the scratch and/or defect at transparent insulation substrate 2 that cannot be removed by substrate cleaning and/or rubbing, or the scratch and/or defect at transparent electrode layer 3, to ensure electrical insulation of transparent electrode layers 3b-3c. By radiating the second laser beam LR2 for the repair in a direction shifted perpendicular to the longitudinal direction of separation trench Tb, relative to laser beam LR1, removal of removal deficient site DP is carried out. The shifting distance must be altered depending upon the size of the scratch or defect impeding the laser radiation. The shifting distance must be increased as the size of the defect becomes larger. Although it is desirable to alter the shifting distance depending upon the size of the defect, repairing can be implemented with the shifting distance set constant for the sake of simplifying the processing step. Preferably, the shifting distance is greater than or equal to 5% the trench pattern width.

The repair by laser beam LR2 set forth above may be carried out, but not limited to the state where the surface of transparent electrode layers 3a-3c is facing downwards, as shown in Fig. 8. Further, laser beams LR1 and LR2 may have the same light property, and a laser beam output from the same laser emission unit can also be used.

In the method for fabricating thin film solar cell 1 (Fig. 1 and Fig. 2), the aforementioned repairing may be applied to back electrode layer 5 or the like besides transparent electrode layer 3. A specific manner of repairing will be described hereinafter in accordance with the method for fabricating thin film solar cell 1.

Referring mainly to Fig. 10 (A) and (B), transparent insulation substrate 2 having transparent electrode layer 3 formed is prepared as the step corresponding to step S1 (Fig. 3). Transparent insulation substrate 2 is, for example, a glass substrate. For the material of transparent electrode layer 3, SnO₂ (tin oxide), ITO (indium tin oxide) or ZnO (zinc oxide), for example, can be employed.

Referring mainly to Fig. 11 (A) and (B), transparent electrode layer 3 is radiated with a laser beam LM1 (first laser beam) through transparent insulation substrate 2 as the step corresponding to step S2 (Fig. 3). The wavelength of laser beam LM1 is selected such that light absorption occurs mainly at transparent electrode layer 3, and is 1064 nm, for example. By laser scribing through this laser beam LM1, a first separation trench 6 separating transparent electrode layer 3 into a plurality of regions is formed.

Instead of radiating laser beam LM1 to transparent electrode layer 3 through transparent insulation substrate 2, transparent electrode layer 3 may be radiated directly without the passage of the laser beam through transparent insulation substrate 2. In other words, laser beam LM1 may be radiated from above, instead of from below as shown in Fig. 11 (B).

By steps S3 and S4 (Fig. 3), electrical insulation of first separation trench 6 is ensured. Specifically, transparent electrode layer 3 remaining at removal deficient site DP, i.e. residue transparent electrode layer 3R, is removed by repairing RP1, as shown in Fig. 18. Repairing RP1 is carried out by a laser beam (second laser beam) having a wavelength similar to that of laser beam LM1, for example.

Referring to Fig. 12 (A) and (B), semiconductor photoelectric conversion layer 4 covering transparent electrode layer 3 so as to fill first separation trench 6 is formed. Semiconductor photoelectric conversion layer 4 has a configuration in which a p layer, i layer, and n layer formed of amorphous silicon thin films are sequentially stacked.

Referring to Fig. 13 (A) and (B), laser beam LM2 is radiated to transparent electrode layer 3 and semiconductor photoelectric conversion layer 4 through transparent insulation substrate 2. The wavelength of laser beam LM2 is selected such that light absorption occurs mainly at semiconductor photoelectric conversion layer 4, and is 532 nm, for example. Accordingly, contact line 7 is formed by ablating a portion of semiconductor photoelectric conversion layer 4.

Instead of radiating laser beam LM2 to semiconductor photoelectric conversion layer 4 through transparent insulation substrate 2, semiconductor photoelectric conversion layer 4 may be directly radiated without the passage of the laser beam through transparent insulation substrate 2. In other words, laser beam LM2 may be radiated from above, instead of from below as in Fig. 13 (B).

Referring mainly to Fig. 14 (A) and (B), a back electrode layer 5 is formed, covering semiconductor photoelectric conversion layer 4 so as to fill contact line 7, as the step corresponding to step S1 (Fig. 3).

Referring mainly to Fig. 15 (A) and (B), laser beam LM3 (first laser beam) is radiated to transparent electrode layer 3, semiconductor photoelectric conversion layer 4, and back electrode layer 5 through transparent insulation substrate 2, as the step corresponding to step S2 (Fig. 3). The wavelength of laser beam of LM3 is selected such that light absorption occurs mainly at semiconductor photoelectric conversion layer 4, and is 532 nm, for example. Accordingly, a second separation trench 8 is formed by ablating semiconductor photoelectric conversion layer 4 and back electrode layer 5 partially.

Laser beam LM3 is preferably radiated to semiconductor photoelectric conversion layer 4 through transparent insulation substrate 2, as described above. In other words, laser beam LM3 is preferably radiated from below in Fig. 15 (B). This is because sufficient ablation cannot be effected readily since the ratio of laser beam LM3, when radiated from above in Fig. 15 (B), reaching semiconductor photoelectric conversion layer 4 is reduced due to reflectance by back electrode layer 5.

Then, steps S3 and S4 (Fig. 3) are carried out to ensure electrical insulation of second separation trench 8. In other words, semiconductor photoelectric conversion layer 4 and back electrode layer 5 remaining at the removal deficient site, i.e. residue back electrode layer 5R, is removed by repairing RP2, as shown in Fig. 19.

As a way of repair RP2, ablation of residue back electrode layer 5R can be employed by directing laser beam LR2 (second light beam) from the substrate side of transparent insulation substrate 2 through transparent insulation substrate 2, after the defect adhering to transparent insulation substrate 2 is removed by substrate cleaning or rubbing. Alternatively, the approach of shifting the position receiving the emitting laser beam LR2 (second light beam), and directing laser beam L2 (second light beam) from the side of transparent insulation substrate 2 may be employed, avoiding the scratch and/or defect at transparent insulation substrate 2 that cannot be removed by substrate cleaning and/or rubbing, to ensure electrical insulation of second separation trench 8. By radiating the second laser beam LR2 for the repair in a direction shifted perpendicular to the longitudinal direction of separation trench Tb, relative to laser beam LR1, removal of removal deficient site DP is carried out. The shifting distance must be altered depending upon the size of the scratch or defect impeding the laser radiation. The shifting distance must be increased as the size of the defect is larger. Although it is desirable to alter the shifting distance depending upon the size of the defect, repairing can be implemented with the shifting distance set constant for the sake of simplifying the processing step. Preferably, the shifting distance is greater than or equal to 5% the trench pattern width.

Referring mainly to Fig. 16 (A) and (B), a laser beam LM4 (first laser beam) is radiated to transparent electrode layer 3, semiconductor photoelectric conversion layer 4, and back electrode layer 5 through transparent insulation substrate 2, as a step corresponding to step S2 (Fig. 3). The wavelength of laser beam LM4 is selected such that light absorption occurs mainly at semiconductor photoelectric conversion layer 4, and is 532 nm, for example. Accordingly, an edge trench 9 is formed adjacent to either end of second separation trench 8 in the longitudinal direction (left and right sides in Fig. 16 (A)) by ablation of a portion of semiconductor photoelectric conversion layer 4 and back electrode layer 5. By subsequent steps S3 and S4 (Fig. 3), electrical insulation of edge trench 9 is ensured.

Referring to Fig. 17 (A) and (B), a laser beam LM5 is radiated to the region at the outer side of edge trench 9 (the outer side of the broken line in Fig. 17 (A)), and the outer side region along the extending direction of second separation trench 8 (left and right sides in Fig. 17 (B)), i.e. the perimeter region of the substrate. The wavelength of laser beam LM5 is selected such that light absorption occurs mainly at transparent electrode layer 3, and is 1064 nm, for example. Accordingly, transparent electrode layer 3, semiconductor photoelectric conversion layer 4, and back electrode layer 5 are ablated partially. Then, by steps S3 and S4 (Fig. 3), electrical insulation of the substrate perimeter region is ensured. Specifically, transparent electrode layer 3 remaining at the removal deficient site is removed by repairing RP3. Repairing RP3 is carried out by a laser beam (second laser beam) having a wavelength identical to that of laser beam LM5, for example.

Referring to Fig. 2 (A) and (B), an electrode 10 extending in a direction identical to the extending direction of second separation trench 8 is formed on the surface of back electrode layer 5 at either side in a direction orthogonal to the extending direction of second separation trench 8.

Thus, thin film solar cell 1 identified as a photoelectric conversion device of the present embodiment is obtained.

According to the present embodiment, reduction in the process yield can be suppressed since removal deficient site DP is repaired even in the case where removal deficient site DP is produced in separating transparent electrode layer 3 (Fig. 4) into transparent electrode layers 3 a-3 c (Fig. 5 (A)) by laser beam LR1 (Fig. 5 (A)) through transparent insulation substrate 2.

### (Fourth Embodiment)

In order to fabricate thin film solar cell 1 (Fig. 1) identified as a photoelectric conversion device in the first embodiment, a laser scribing step (Fig. 5 (A) and (B)) was carried out, followed by a repairing step on removal deficient site DP from the laser scribing step. In the present embodiment, repairing is carried out at a position shifted from the position where laser scribing was carried out. In other words, repairing is performed by carrying out film removal at a site avoiding removal deficient site DP where removal is difficult. A thin film solar cell 1 of the present embodiment, particularly a transparent insulation film and transparent electrode layer thereof, will be described hereinafter.

Referring mainly to Fig. 24, a configuration of a solar cell in the present embodiment will be first described. The thin film solar cell of the present embodiment includes a transparent insulation substrate 2, and transparent electrode layers 3a-3c (plurality of regions) formed on transparent insulation substrate 2. Transparent electrode layers 3a-3c are separated by first and second separation trenches Ta, TbR (plurality of separation trenches). First separation trench Ta has a first width WS. Second separation trench TbR has a second width WR larger than first width WS. Second separation trench TbR has a first side D1 close to first separation trench Ta and a second side D2 remote from first separation trench Ta. Second separation trench TbR includes an unprocessed region CN having a third width WC that is greater than or equal to first width WS, locally at second side D2.

Thin film solar cell 1 has a plurality of separation trenches (not shown in Fig. 24) provided in addition to first and second separation trenches Ta, TbR all or most having a width identical to first width WS.

A method for fabricating a thin film solar cell of the present embodiment will be described hereinafter.

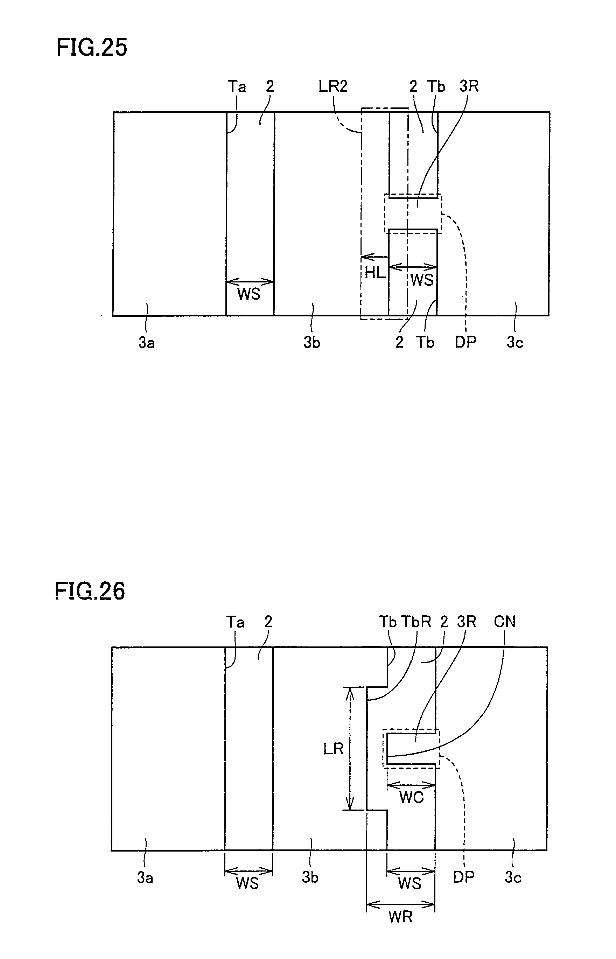

Referring mainly to Fig. 25, transparent electrode layers 3a-3c are formed on transparent insulation substrate 2 by a laser scribing step, similar to Fig. 5 (B) in the first embodiment. In other words, separation trenches Ta and Tb are formed, likewise with the first embodiment. Then, repairing is carried out by laser beam LR2 (Fig. 9), likewise with the first embodiment. The difference lies in that the radiated position by laser beam LR2 in the present embodiment is shifted by a distance HL in a direction perpendicular to the extending direction of separation trench Tb, and in a direction from second side D2 towards first side D1, relative to the radiated position by laser beam LR1 (Fig. 5 (A)). Distance HL is greater than or equal to first width WS.

As a result of repair by laser beam LR2 with the radiation position being shifted, as set forth above, a configuration shown in Fig. 24 is obtained. Specifically, second separation trench TbR obtained as a result of the repair on separation trench Tb has a second width WR corresponding to the sum of first width WS and distance HL. It is preferable to determine distance HL taking third width WC into account.

Most of residue transparent electrode layer 3R still remains at removal deficient site DP even after the above-described repairing (Fig. 24). This is because the incidence of each of laser beam LR1 (Fig. 5 (A)) and LR2 (Fig. 9) is impeded by the defect or scratch on transparent insulation substrate 2. In accordance with the present embodiment, repairing can be carried out even in the case where there is residue transparent electrode layer 3R that is difficult to remove.

A first modification will be described hereinafter. Repairing is carried out on the entirety of separation trench Tb (Fig. 25) in the embodiment set forth above. In the present modification, repairing is carried out only on separation trench Tb corresponding to a length LR, including removal deficient site DP, as shown in Fig. 26. The location of removal deficient site DP in separation trench Tb is identified prior to repair. This identification can be carried out using image recognition technique, for example.

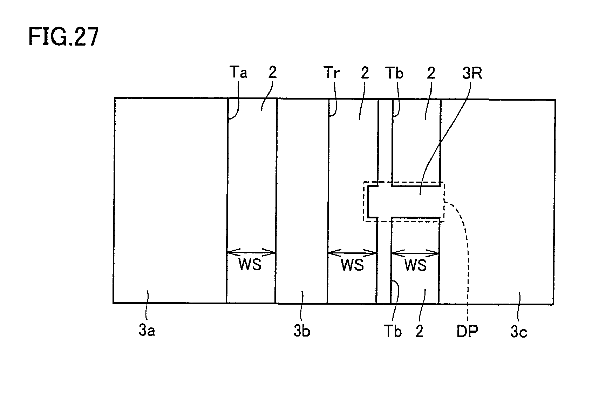

A second modification will be described hereinafter. Distance HL in the embodiment set forth above (Fig. 25) is less than or equal to first width WS. In the present modification, distance HL is larger than first width WS. As a result, separation trench Tr is formed by repairing, between separation trenches Ta and Tb, as shown in Fig. 27.

A configuration based on an arbitrary combination of a separation trench repaired as in the embodiment set forth above, a separation trench repaired as in the first modification, and a separation trench repaired as in the second modification can be used.

Although the repair of a separation trench in the transparent electrode layer is described above, the repair can be carried out similarly to another layer in thin film solar cell 1.

Although the present invention has been described and illustrated in detail, it is clearly understood that the same is by way of illustration and example only and is not to be taken by way of limitation. The scope of the present invention is defined by the terms of the claims, rather than the description of the embodiments set forth above, and is intended to include any modifications within the scope and meaning equivalent to the terms of the claims.

### INDUSTRIAL APPLICABILITY

The present invention is advantageously applicable particularly to a film removal method, a method for fabricating a photoelectric conversion device, and a film removal device.

### DESCRIPTION OF THE REFERENCE SIGNS

CN unprocessed region; DP removal deficient site; LM1-LM5, LR1 laser beam (first laser beam); LR2 laser beam (second laser beam); ND needle; RM resistance meter; Ta separation trench (first separation trench); Tb separation trench; TbR separation trench (second separation trench); 1, 1v thin film solar cell (photoelectric conversion device); 2 transparent insulation substrate (substrate); 3, 3a-3c transparent electrode layer (film); 3R residue transparent electrode layer; 4 semiconductor photoelectric conversion layer; 5 back electrode layer; 5R residue back electrode layer; 6 first separation trench; 7 contact line; 8 second separation trench; 9 edge trench; 10 electrode; 11 cell region; 60 film removal device; 61 support roller; 62 probe; 63 CCD camera; 64 laser emission unit; 65 X-Y robot; 610 holding unit; 620 resistance measurement unit; 630 image recognition unit; 640 treatment unit; 650 shift control unit; 660 processing unit; 661 resistance value determination unit; 662 location identification unit.

## Claims

1. A film removal method comprising the steps of:
radiating a film (3) formed on a substrate (2) with a first light beam to separate said film into a plurality of regions, and
repairing (RP1) by removing said film at a removal deficient site (DP) where said film remains between said plurality of regions.

2. The film removal method according to claim 1, wherein said repairing step includes the step of removing said film at said removal deficient site by radiating said film with a second light beam.

3. The film removal method according to claim 2, wherein a face through which said second light beam enters said substrate is opposite to the face through which said first light beam enters said substrate.

4. The film removal method according to claim 2, wherein said repairing step is carried out from a side of said substrate where said film is formed.

5. The film removal method according to any of claims 2-4, wherein said second light beam is radiated under a state where a surface of said film is facing downwards.

6. The film removal method according to any of claims 2-5, wherein said step of removing said film at said removal deficient site by radiating said film with a second light beam is carried out by radiating said second light beam to a position shifted by a predetermined distance from the position radiated with said first light beam.

7. The film removal method according to claim 1, wherein said repairing step includes the step of removing said film at said removal deficient site by mechanical machining from a side of said substrate where said film is formed.

8. The film removal method according to any of claims 1-7, wherein said substrate has transparency, and said first light beam is radiated to said film through said substrate.

9. The film removal method according to any of claims 1-8, further comprising the step of identifying a location of said removal deficient site, prior to said repairing step.

10. The film removal method according to claim 9, wherein said step of identifying a location of said removal deficient site includes the step of carrying out image recognition on a site where said film is separated.

11. The film removal method according to claim 9 or 10, wherein
said film is a conductive film, and
said step of identifying a location of said removal deficient site includes the step of measuring electrical resistance between said plurality of regions.

12. The film removal method according to any of claims 9-11, wherein said repairing step is carried out at a location identified by the step of identifying a location of said removal deficient site.

13. The film removal method according to any of claims 9-12, wherein said repairing step is carried out in spots at a location identified by the step of identifying a location of said removal deficient site.

14. A method for fabricating a photoelectric conversion device (1), comprising the steps of:
radiating a film (3) formed on each of a plurality of substrates (2) with a first light beam to separate said film into a plurality of regions,
measuring electrical resistance between said plurality of regions for each of said plurality of substrates,
identifying at least one defective substrate from said plurality of substrates, based on the electrical resistance measured at said measuring step, and
repairing by removing said film at a removal deficient site where said film remains between said plurality of regions, for each said at least one defective substrate.

15. A photoelectric conversion device comprising:
a substrate (2), and
a film formed on said substrate, and separated into a plurality of regions by a plurality of separation trenches, said plurality of separation trenches including a first separation trench (Ta) and a second separation trench (TbR), said first separation trench having a first width (WS), said second separation trench having a second width (WR) larger than said first width, and including an unprocessed region (CN) having a third width (WC) greater than or equal to said first width, locally at one side of said second separation trench.

16. A film removal device (60) comprising:
a holding unit (610) for holding a substrate,
an image recognition unit (630) carrying out image recognition at a surface of said substrate held by said holding unit, and
a treatment unit (640) for carrying out treatment at an identified location on said substrate held at said holding unit based on said image recognition.

17. The film removal device according to claim 16, further comprising a resistance measurement unit (620) for measuring electrical resistance at an identified site of said substrate held at said holding unit,
wherein said image recognition is carried out based on said measured electrical resistance.

18. The film removal device according to claim 16 or 17, wherein said treatment unit is a laser emission unit (64) for emitting a laser beam.

19. The film removal device according to claim 16 or 17, wherein said treatment unit functions to carry out mechanical machining.
